# FASCICULE DE BREVET EUROPEEN

(11) **EP 4 172 690 B1**
(45) Date de publication et mention de la délivrance du brevet: **23.07.2025**
(21) Numéro de dépôt: 21740151.2
(22) Date de dépôt: 22.06.2021
(51) Int. Cl.: G02F 1/01, G02F 1/015

(54) **PROCÉDÉ DE FABRICATION D'UN COMPOSANT THERMO-OPTIQUE**
VERFAHREN ZUR HERSTELLUNG EINES THERMOOPTISCHEN BAUTEILS
METHOD FOR MANUFACTURING A THERMO-OPTIC COMPONENT

(30) Priorité: 29.06.2020 FR 2006801
(43) Date de publication de la demande: 03.05.2023
(73) Titulaire: SOITEC, 38190 Bernin (FR)
(72) Inventeur: SCIANCALEPORE, Corrado, 38950 SAINT-MARTIN-LE-VINOUX (FR); GHYSELEN, Bruno, 38170 SEYSSINET (FR); DELPY, Alain, 38210 TULLINS (FR); CAILLER, Céline, 38610 GIERES (FR); HERISSON, David, 38320 EYBENS (FR); ALAMI-IDRISSI, Aziz, 38660 LE TOUVET (FR)
(74) Mandataire: IP Trust
(86) Numéro de dépôt international: PCT/FR2021/051128
(87) Numéro de publication internationale: WO 2022/003270

(56) Documents cités:
- WO-A1-02/44777
- US-A- 6 031 957
- US-A1- 2009 297 092
- US-A1- 2015 253 510
- US-A1- 2019 293 863
- US-A1- 2019 369 328
- US-B1- 10 416 380

## Description

La présente invention concerne le domaine de la photonique. Elle concerne en particulier un procédé de fabrication d'un composant thermo-optique, c'est-à-dire dont les propriétés optiques (l'indice de réfraction au premier ordre) sont modifiées par une variation locale ou globale de température, imposée par une source de chaleur interne ou externe au composant.

### ARRIERE PLAN TECHNOLOGIQUE DE L'INVENTION

La photonique sur silicium gagne de plus en plus d'intérêt car cette technologie permet d'améliorer les liaisons de communication optique en fournissant de nombreuses fonctionnalités intégrées, telles que des commutateurs et des déphaseurs optiques, des modulateurs, des filtres, des lasers, etc.

Les commutateurs et les déphaseurs optiques, notamment, doivent pouvoir véhiculer efficacement une grande quantité de signal tout en respectant des spécifications de compacité, de faible consommation de puissance et de rapidité de commutation. Parce que le silicium procure un fort effet thermo-optique, des commutateurs thermo-optiques compacts et rapides ont pu être développés sur des substrats SOI (silicium sur isolant) ; on peut notamment citer les composants de type résonateur en anneau (« ring resonator » selon la terminologie anglo-saxonne) ou de type interféromètre de Mach-Zehnder.

Le document US 2019/293863 divulgue une méthode de fabrication de circuit intégér photonique (PIC).

Le document US2015253510 propose un commutateur thermo-optique compact qui minimise grandement la puissance requise pour opérer la commutation, du fait de la formation d'un guide d'onde optique suspendu au-dessus du substrat support, majoritairement entouré d'air et maintenu audit substrat support par le biais de piliers limitant le flux de chaleur : le confinement thermique améliore l'efficacité (limite la consommation de puissance) du commutateur. L'architecture de ce commutateur thermo-optique est obtenue à partir d'un substrat SOI ; la couche superficielle de silicium et l'oxyde enterré forment respectivement le cœur du guide d'onde optique et une partie de la couche de confinement optique autour du cœur, et un élément chauffant est disposé sur le guide d'onde. Des étapes de structuration et de gravure par la face avant du substrat SOI permettent de former des tranchées profondes et un interstice d'air entre le guide d'onde et le substrat support.

Un inconvénient d'une telle architecture peut venir du fait que plusieurs zones de la périphérie du composant thermo-optique sont en contact avec de l'air : sa réponse transitoire aux variations de température imposées par l'élément chauffant va donc être dégradée. En particulier, le temps nécessaire pour que le guide d'onde revienne à une température T0, en partant d'une température plus élevée T1, appelé temps de descente (« fall time » selon la terminologie anglo-saxonne), lors de l'arrêt de l'élément chauffant, est augmenté du fait de l'inertie thermique générée par l'air environnant.

### OBJET DE L'INVENTION

La présente invention concerne une solution alternative aux solutions connues de l'état de la technique. L'invention concerne un procédé de fabrication d'un composant thermo-optique autorisant une bonne isolation thermique, favorable à l'efficacité du phénomène thermo-optique, tout en conservant une très bonne dynamique de réponse transitoire du composant. Le procédé de fabrication confère également une grande densité d'intégration et une excellente stabilité mécanique au composant, tout en simplifiant les étapes de fabrication.

### BREVE DESCRIPTION DE L'INVENTION

La présente invention concerne un procédé de fabrication d'un composant thermo-optique comprenant les étapes suivantes :
a) la fourniture d'un substrat silicium sur isolant (SOI) comportant :
   - une couche superficielle en silicium monocristallin, s'étendant selon un plan principal et disposée sur une couche diélectrique, elle-même disposée sur un support en silicium, et
   - au moins une cavité enterrée, aménagée dans le support et débouchant sous la couche diélectrique,
b) la formation d'un guide d'onde optique s'étendant dans le plan principal et comprenant un cœur formé dans la couche superficielle et entouré par une couche de confinement optique incluant la couche diélectrique,
c) l'élaboration d'au moins un élément de chauffage, sur le guide d'onde optique, ledit élément de chauffage étant positionné, dans le plan principal, à l'aplomb d'une portion du guide d'onde optique, ou de part et d'autre de ladite portion, l'élément de chauffage et la portion du guide d'onde optique se trouvant à l'aplomb de la -au moins une- cavité enterrée.

Selon des caractéristiques avantageuses de l'invention, prises seules ou selon toute combinaison réalisable :
- à l'étape b), une ouverture est aménagée à travers le guide d'onde optique, pour mettre la -au moins une- cavité à une pression extérieure ;
- ladite ouverture est conservée ou rebouchée de manière à sceller hermétiquement la -au moins une- cavité ;
- la -au moins une- cavité demeure hermétiquement scellée tout au long des étapes a), b) et c) ;
- la couche diélectrique est en oxyde de silicium et présente une épaisseur comprise entre 100nm et 3 microns ;
- la couche superficielle présente une épaisseur comprise entre 100nm et 500nm ;
- la couche de confinement optique comprend une couche diélectrique additionnelle présentant une épaisseur comprise entre 0,5 et 1,5 microns ;
- la -au moins une- cavité présente des dimensions latérales, dans le plan principal, comprises entre 10 microns et quelques millimètres, et une profondeur, selon un axe normal au plan principal, comprise entre quelques microns et 100 microns, avantageusement entre 5 et 10 microns.

### BREVE DESCRIPTION DES DESSINS

D'autres caractéristiques et avantages de l'invention ressortiront de la description détaillée qui va suivre en référence aux figures annexées sur lesquelles :
- Les figures 1a à 1d présentent des séquences de procédé pour la fourniture du substrat SOI de l'étape a) du procédé de fabrication conforme à l'invention ;
- La figure 2 présente l'étape b) du procédé de fabrication conforme à l'invention ;
- La figure 3 présente l'étape c) du procédé de fabrication conforme à l'invention ;
- Les figures 4a et 4b présentent deux architectures, en vue de dessus, de composants thermo-optiques élaborés avec le procédé de fabrication conforme à l'invention.

Les figures sont des représentations schématiques qui, dans un objectif de lisibilité, ne sont pas nécessairement à l'échelle. En particulier, les épaisseurs des couches selon l'axe z ne sont pas à l'échelle par rapport aux dimensions latérales selon les axes x et y.

Les mêmes références sur les figures pourront être utilisées pour des éléments de même nature.

Les différentes possibilités (variantes et modes de réalisation illustrés et/ou détaillés dans la description à suivre) doivent être comprises comme n'étant pas exclusives les unes des autres et peuvent se combiner entre elles.

### DESCRIPTION DETAILLEE DE L'INVENTION

L'invention concerne un procédé de fabrication d'un composant thermo-optique. On entend par composant thermo-optique tout type de dispositif optoélectronique, tel qu'un commutateur, un déphaseur, un modulateur, un coupleur directionnel, un filtre et un multiplexeur optique, un émetteur laser, un amplificateur, etc., dont les propriétés optiques (en particulier, son indice de réfraction au premier ordre) sont modifiées par une variation locale (ou globale) de la température imposée par une source de chaleur interne ou externe au dispositif.

Le procédé de fabrication prévoit la réalisation d'un guide d'onde optique 50 à base de silicium monocristallin et d'un élément de chauffage 60, à proximité d'une portion du guide d'onde 50 : les variations de température imposées par l'élément de chauffage 60 à une portion 52' du cœur en silicium du guide d'onde 50 auront pour effet de modifier l'indice de réfraction du silicium, changeant ainsi l'indice effectif du mode optique dans ledit guide 50.

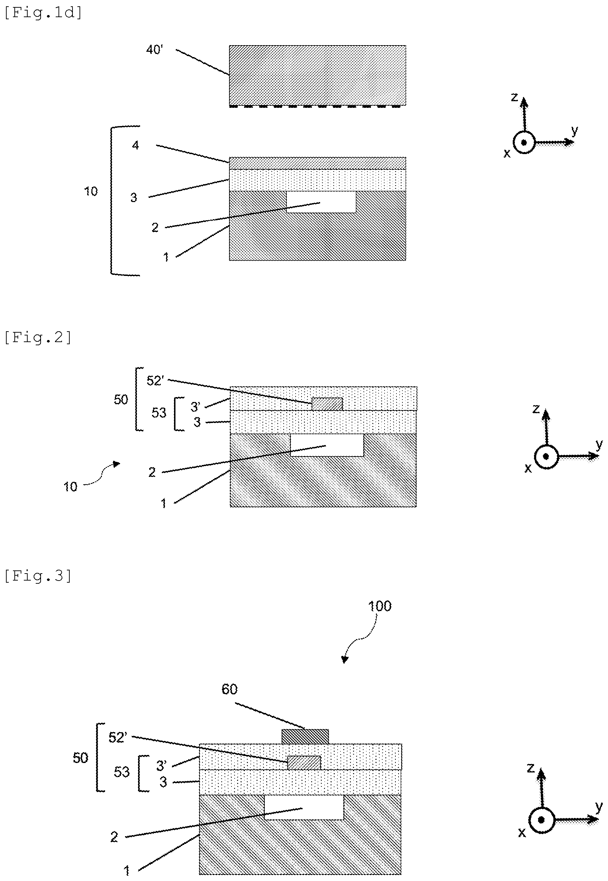

Le procédé de fabrication comprend une étape a) de fourniture d'un substrat silicium sur isolant (SOI) 10 comportant une couche superficielle 4 en silicium monocristallin, s'étendant selon un plan principal (x,y) et disposée sur une couche diélectrique 3, elle-même disposée sur un support en silicium 1 (figure 1d). Le substrat SOI 10 se présente préférentiellement sous la forme d'une plaquette circulaire, de diamètre compris entre 150mm et 450mm, l'épaisseur du support 1 variant typiquement entre 300 microns et 1000 microns.

Avantageusement, pour répondre aux besoins des applications photoniques, la couche superficielle 4 présente une épaisseur comprise entre 100nm et 500nm. Cette couche superficielle 4 est destinée à former le cœur d'un guide d'onde optique 50. Toujours avantageusement, mais sans que cela soit limitatif, la couche diélectrique 3 est en oxyde de silicium et présente une épaisseur comprise entre 100nm et 3 microns.

Le substrat SOI 10 comprend en outre au moins une cavité enterrée 2, aménagée dans le support 1 et débouchant sous la couche diélectrique 3. Par la suite, nous parlerons d'une cavité enterrée 2 par souci de simplification, mais il est bien entendu que le substrat SOI 10 comprend avantageusement une pluralité de cavités 2, réparties dans le plan principal (x,y) conformément à l'architecture, au type et au nombre de composants thermo-optiques 100 prévus sur ledit substrat SOI 10. Notons également que toutes les cavités enterrées 2 ne présentent pas nécessairement les mêmes dimensions (longueur et largeur dans le plan principal (x,y), et profondeur selon l'axe z normal au plan principal (x,y)), car elles peuvent être associées à différentes architectures ou types de composant.

La cavité enterrée 2 peut présenter des dimensions latérales, dans le plan principal (x,y), comprises entre 10 microns et quelques millimètres, et une profondeur comprise entre quelques microns et 100 microns, avantageusement entre 5 et 10 microns. Elle peut présenter une forme quelconque dans le plan principal (x,y), par exemple, carrée, rectangulaire, polygonale, circulaire, annulaire, etc.

La cavité enterrée 2 du substrat SOI 10 peut être remplie d'un matériau solide sacrificiel ou en être dépourvue. Dans ce dernier cas, elle peut être remplie d'air ou de gaz à pression atmosphérique ou à une pression contrôlée déterminée.

A titre d'exemple, le matériau sacrificiel pourra être choisi parmi l'oxyde de silicium par exemple à faible niveau de densification ou dopé, le silicium poly-cristallin dopé, le silicium poreux, etc. Le matériau sacrificiel pourra éventuellement présenter une vitesse de gravure suffisamment grande par rapport aux autres matériaux du substrat SOI 10, à savoir par rapport à l'oxyde de silicium thermique et au silicium monocristallin, de manière à éviter une attaque significative du substrat 10 lorsque ce matériau sacrificiel sera retiré, ultérieurement dans le procédé.

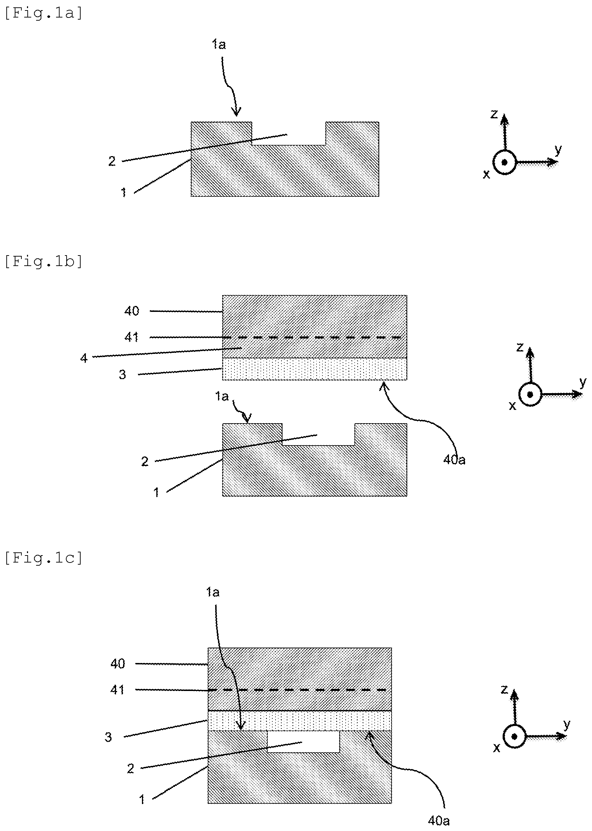

L'élaboration d'un tel substrat SOI 10 avec cavité enterrée 2 est préférentiellement basée sur le procédé de transfert de couches minces connu sous l'appellation procédé Smart Cut^{™}. Préalablement au report de la couche superficielle 4, le support 1 utilisé est un substrat de silicium monocristallin dont la face avant 1a a été gravée pour former la -au moins une- cavité 2 (figure 1a). Dans la variante où la cavité 2 est remplie d'un matériau sacrificiel, ledit matériau est ensuite déposé dans la cavité 2 de manière à venir affleurer la surface en silicium de la face avant 1a.

La formation des cavités et leur remplissage éventuel fait appel à des étapes classiques de photolithographie, masquage, gravures, dépôt et polissage qui ne seront pas décrites ici.

Un substrat donneur 40 en silicium monocristallin est implanté par sa face avant 40a, de manière à définir un plan fragile enterré 41 sensiblement parallèle à la face avant 40a et délimitant, avec cette dernière, la couche mince 3,4 à reporter (figure 1b). L'implantation est habituellement faite avec des espèces légères telles que des ions d'hydrogène, d'hélium ou une combinaison de ces deux espèces. Le plan fragile 41 est ainsi nommé car il comprend des nano-fissures sous forme lenticulaire générées par les espèces légères implantées.

Selon une option préférentielle, la couche mince 3,4 à reporter comprend, de la face avant 40a du substrat donneur 40 jusqu'au plan fragile enterré 41, une couche diélectrique 3 et une couche en silicium 4 lesquelles formeront respectivement la couche diélectrique enterrée 3 et la couche superficielle 4 en silicium du substrat SOI 10. On comprendra donc que l'énergie d'implantation des espèces légères est choisie et ajustée de manière à former le plan fragile enterré (plus ou moins localisé au niveau du pic d'implantation) à la profondeur correspondant à l'épaisseur souhaitée de couche superficielle 4, en tenant compte d'étapes de finition (évoquées ci-après) qui consomment une partie de matière de ladite couche 4.

Le substrat donneur 40 et le support 1 sont ensuite assemblés, par collage direct entre les faces avant 40a,1a desdits substrats 40,1, pour former une structure collée (figure 1c). Des nettoyages et/ou activations de surface des faces avant 40a, 1a, bien connus dans le domaine du collage par adhésion moléculaire, pourront être opérés pour obtenir une excellente qualité de collage. Un assemblage en atmosphère contrôlée est possible ; il permet notamment de maîtriser la pression dans les cavités (enterrées suite audit assemblage), lorsque celles-ci sont dépourvues de matériau sacrificiel.

La séparation au niveau du plan fragile enterré 41 s'effectue préférentiellement par application d'un traitement thermique à température moyenne, typiquement entre 350°C et 500°C, du fait de la croissance de microfissures par coalescence et mise sous pression des espèces gazeuses (figure 1d). Alternativement ou conjointement, la séparation peut être provoquée par l'application d'une contrainte mécanique à la structure collée. A l'issue de cette séparation, on obtient un substrat SOI intermédiaire d'une part, et le reste 40' du substrat donneur, d'autre part. Des séquences de finition comprenant des nettoyages, des traitements de surface (gravure, polissage, etc.) et/ou des traitements thermiques sont habituellement appliquées au substrat SOI intermédiaire, de manière à restaurer un bon état de surface (défectivité et rugosité) et une bonne qualité cristalline à la couche superficielle 4 en silicium. A la suite de quoi, le substrat SOI 10 est disponible.

Bien que l'élaboration du substrat SOI 10 avec cavité enterrée 2 ait été décrit ici en référence au procédé Smart Cut, un tel substrat SOI 10 peut également être réalisé à partir d'autres procédés de transfert de couches minces connus de l'état de la technique.

Le procédé de fabrication selon l'invention comprend ensuite une étape b) de formation d'un guide d'onde optique 50 s'étendant dans le plan principal (x,y) et comprenant un cœur 52,52' formé dans la couche superficielle 4 et entouré par une couche de confinement optique 53 incluant la couche diélectrique 3 (figure 2).

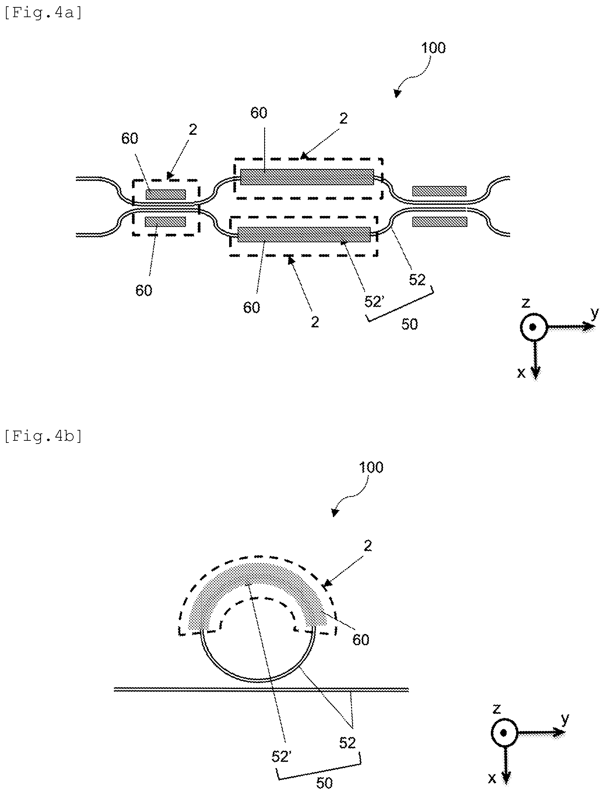

La formation du guide d'onde optique 50 requiert une gravure locale de la couche superficielle 4, de manière à définir les dimensions et la forme du guide dans le plan principal (x,y). Les figures 4a et 4b illustrent deux architectures différentes de guide d'onde 50, respectivement dans le cas d'un interféromètre de Mach-Zehnder et dans le cas d'un résonateur en anneau, en vue de dessus, c'est-à-dire dans le plan principal (x, y). On retrouve le cœur 52,52' du guide d'onde 50, dont une ou plusieurs portion(s) 52' est(sont) situées à l'aplomb de la (ou des) cavité(s) 2 (représentée(s) en pointillés sur les figures 4a, 4b). La longueur du cœur 52 dans le plan principal (x,y) peut varier selon l'architecture visée ; sa largeur est habituellement comprise entre 0,2 et 1 micron, préférentiellement entre 0,3 et 0,6 micron.

La formation du guide d'onde optique 50 requiert également le dépôt d'une couche diélectrique additionnelle 3', sur le cœur 52,52', de manière à encapsuler ce dernier dans une gaine, appelée ici couche de confinement optique 53, incluant la couche diélectrique 3 du substrat SOI 10. La couche diélectrique additionnelle 3' est préférentiellement en oxyde de silicium. Son épaisseur est typiquement comprise entre 0,5 et 1,5 microns.

A l'étape b), avantageusement après la formation du guide d'onde 50, une ouverture (non représentée) peut être aménagée à travers le guide d'onde optique 50, pour mettre la -au moins une- cavité 2 à une pression extérieure. L'ouverture est typiquement réalisée à travers la couche de confinement 53, hors de la zone comprenant le cœur 52,52' en silicium. Cette ouverture pourra être conservée ou rebouchée pour sceller la cavité 2 après cette mise à la pression extérieure.

Dans le cas où la cavité enterrée 2 est remplie d'un matériau sacrificiel, une (au moins) ouverture est aménagée de manière à accéder audit matériau et à pratiquer une gravure, sèche ou humide, visant à retirer le matériau et à vider la cavité enterré 2 de son matériau solide. Là encore, l'ouverture pourra être conservée ou rebouchée après vidage de la cavité 2.

Rappelons que la cavité 2 est hermétiquement scellée à l'issue de l'étape a) et peut, dans certains modes de réalisation, rester dans cet état au cours des étapes b) et/ou c), voire après fabrication du composant thermo-optique, lors de son utilisation. Le caractère hermétique de la cavité 2 permet d'éviter des phénomènes de pénétration parasite d'espèces gazeuses, liquides dans cette cavité 2 pendant le procédé de fabrication, lesquels génèrent des problèmes potentiels de séchage, de collage de la membrane supérieure, de contaminations diverses, de dégradation de la membrane supérieure, etc. Maintenir la cavité 2 hermétique lors de l'utilisation du composant peut également permettre d'assurer la reproductibilité du point de fonctionnement (notamment en termes d'environnement thermique et de déformation mécanique).

Le procédé de fabrication comprend ensuite une étape c) d'élaboration d'au moins un élément de chauffage 60, sur le guide d'onde optique 50 (figure 3). Cet élément de chauffage 60 est disposé, dans le plan principal (x,y) à l'aplomb de la cavité enterrée 2. Avantageusement, les dimensions dans ce plan de l'élément de chauffage 60 sont inférieures à celles de la cavité 2, comme cela est illustré sur les figures 3, 4a et 4b.

Ainsi, toujours dans le plan principal (x,y), l'élément de chauffage 60 se trouve positionné soit à l'aplomb de la portion de cœur 52' du guide d'onde optique 50, soit de part et d'autre de ladite portion 52' (figures 4a, 4b). Cette portion 52' correspond à la partie du guide d'onde 50 qui va subir les variations de températures appliquées par l'élément de chauffage 60, et qui va donc conférer ses propriétés thermo-optiques au composant 100.

Selon un exemple particulier de réalisation, l'élément de chauffage 60 est formé par dépôt d'un empilement Ti/TiN directement sur la couche de confinement 53, à l'aplomb de la portion 52' du guide d'onde. L'empilement peut présenter une épaisseur de l'ordre de 100nm.

L'élément de chauffage 60 comprend en outre deux plots de contact métalliques, destinés à être connectés à une source de courant. Lorsqu'un courant est appliqué, l'élément chauffant 60 dissipe de la chaleur par effet Joule et augmente ainsi la température subie par la portion 52' de cœur du guide d'onde 50.

Le procédé de fabrication selon l'invention est simple et efficace : il limite les étapes technologiques de définition et d'isolation du composant thermo-optique 100, notamment basées sur des gravures chimiques souvent difficiles à contrôler ; il permet également une grande densité d'intégration. La présence d'une (au moins) cavité enterrée 2 dans le substrat SOI 10 facilite l'isolation thermique de la portion 52' du guide d'onde destinée à développer l'effet thermo-optique, ce qui permet de limiter les pertes thermiques par conduction, l'air ou le gaz dans la cavité constituant un excellent isolant. En parallèle, la continuité thermique de la couche de confinement optique 53 autour du cœur 52 du guide d'onde optique 50 maintient un temps de réponse transitoire faible lors des variations de température de l'élément de chauffage 60, conférant ainsi une très bonne réactivité au composant 100. La présence de la couche diélectrique 3 sous le cœur 52' du guide d'onde optique permet d'aboutir à un bon compromis entre rapidité de réponse du composant et l'efficacité énergétique de son pilotage.

Le procédé de fabrication selon l'invention procure en outre des composants thermo-optique 100 robustes car des gravures complexes par la face avant ou par la face arrière du substrat SOI 10 ne sont pas requises pour former l'isolation, lesquelles gravures sont susceptibles de fragiliser la tenue mécanique du composant.

## Revendications

1. Procédé de fabrication d'un composant thermo-optique (100) comprenant les étapes suivantes :
a) la fourniture d'un substrat SOI (10) comportant :
- une couche superficielle (4) en silicium monocristallin, s'étendant selon un plan principal (x,y) et disposée sur une couche diélectrique (3), elle-même disposée sur un support (1) en silicium, et
- au moins une cavité enterrée (2), aménagée dans le support (1) et débouchant sous la couche diélectrique (3), puis,
b) la formation d'un guide d'onde optique (50) s'étendant dans le plan principal (x,y) et comprenant un cœur (52,52') formé dans la couche superficielle (4) et entouré par une couche de confinement optique (53) incluant la couche diélectrique (3), puis,
c) l'élaboration d'au moins un élément de chauffage (60), sur le guide d'onde optique (50), ledit élément de chauffage (60) étant positionné, dans le plan principal (x,y), à l'aplomb d'une portion (52') du guide d'onde optique (50), ou de part et d'autre de ladite portion (52'), l'élément de chauffage (60) et la portion (52') du guide d'onde optique se trouvant à l'aplomb de la -au moins une- cavité enterrée (2).

2. Procédé de fabrication d'un composant thermo-optique (100) selon la revendication précédente, dans lequel, à l'étape b), une ouverture est aménagée à travers le guide d'onde optique (50), pour mettre la -au moins une- cavité (2) à une pression extérieure.

3. Procédé de fabrication d'un composant thermo-optique (100) selon la revendication précédente, dans lequel ladite ouverture est rebouchée de manière à sceller hermétiquement la -au moins une- cavité (2).

4. Procédé de fabrication d'un composant thermo-optique (100) selon la revendication 1, dans lequel la -au moins une-cavité (2) demeure hermétiquement scellée tout au long des étapes a), b) et c).

5. Procédé de fabrication d'un composant thermo-optique (100) selon l'une des revendications précédentes, dans lequel la couche diélectrique (3) est en oxyde de silicium et présente une épaisseur comprise entre 100nm et 3 microns.

6. Procédé de fabrication d'un composant thermo-optique (100) selon l'une des revendications précédentes, dans lequel la couche superficielle (4) présente une épaisseur comprise entre 100nm et 500nm.

7. Procédé de fabrication d'un composant thermo-optique (100) selon l'une des revendications précédentes, dans lequel la couche de confinement optique (53) comprend une couche diélectrique additionnelle (3') présentant une épaisseur comprise entre 0,5 et 1,5 microns.

8. Procédé de fabrication d'un composant thermo-optique (100) selon l'une des revendications précédentes, dans lequel la -au moins une- cavité (2) présente des dimensions latérales, dans le plan principal (x,y), comprises entre 10 microns et quelques millimètres, et une profondeur, selon un axe (z) normal au plan principal (x,y), comprise entre quelques microns et 100 microns, avantageusement entre 5 et 10 microns.

9. Procédé de fabrication d'un composant thermo-optique (100) selon l'une des revendications précédentes, dans lequel ledit composant thermo-optique (100) forme un commutateur, un déphaseur, un modulateur, un émetteur laser, un amplificateur, un coupleur directionnel, un filtre et/ou un multiplexeur.

## Patentansprüche

1. Verfahren zur Herstellung eines thermooptischen Bauteils (100), das die folgenden Schritte umfasst:
a) die Bereitstellung eines SOI-Substrats (10) umfassend:
- eine Oberflächenschicht (4) aus monokristallinem Silizium, die sich in einer Hauptebene (x, y) erstreckt und auf einer dielektrischen Schicht (3) angeordnet ist, die ihrerseits auf einem Siliziumträger (1) angeordnet ist, und
- mindestens einen in dem Träger (1) ausgebildeten, unterhalb der dielektrischen Schicht (3) mündenden, unterirdischen Hohlraum (2) und dann
b) die Bildung eines optischen Wellenleiters (50), der sich in der Hauptebene (x, y) erstreckt und einen Kern (52, 52') umfasst, der in der Oberflächenschicht (4) ausgebildet und von einer optischen Begrenzungsschicht (53) umgeben ist, die die dielektrische Schicht (3) einschließt, und dann
c) die Ausarbeitung mindestens eines Heizelements (60) auf dem optischen Wellenleiter (50), wobei das Heizelement (60) in der Hauptebene (x, y) senkrecht zu einem Abschnitt (52') des optischen Wellenleiters (50) oder beiderseits dieses Abschnitts (52') positioniert ist, wobei sich das Heizelement (60) und der Abschnitt (52') des optischen Wellenleiters senkrecht über dem mindestens einen unterirdischen Hohlraum (2) befinden.

2. Verfahren zur Herstellung eines thermooptischen Bauteils (100) nach dem vorstehenden Anspruch, wobei in Schritt b) eine Öffnung durch den Lichtwellenleiter (50) hindurch ausgebildet wird, um den mindestens einen Hohlraum (2) mit einem Außendruck zu beaufschlagen.

3. Verfahren zur Herstellung eines thermooptischen Bauteils (100) nach dem vorstehenden Anspruch, wobei die Öffnung so verschlossen ist, dass der mindestens eine Hohlraum (2) hermetisch abgedichtet ist.

4. Verfahren zur Herstellung eines thermooptischen Bauteils (100) nach Anspruch 1, wobei der mindestens eine Hohlraum (2) während der gesamten Schritte a), b) und c) hermetisch verschlossen bleibt.

5. Verfahren zur Herstellung eines thermooptischen Bauteils (100) nach einem der vorstehenden Ansprüche, wobei die dielektrische Schicht (3) aus Siliziumoxid besteht und eine Dicke zwischen 100 nm und 3 Mikrometern aufweist.

6. Verfahren zur Herstellung eines thermooptischen Bauteils (100) nach einem der vorstehenden Ansprüche, wobei die Oberflächenschicht (4) eine Dicke zwischen 100 nm und 500 nm aufweist.

7. Verfahren zur Herstellung eines thermooptischen Bauteils (100) nach einem der vorstehenden Ansprüche, wobei die optische Begrenzungsschicht (53) eine zusätzliche dielektrische Schicht (3') umfasst, die eine Dicke zwischen 0,5 und 1,5 Mikrometern aufweist.

8. Verfahren zur Herstellung eines thermooptischen Bauteils (100) nach einem der vorstehenden Ansprüche, wobei der mindestens eine Hohlraum (2) in der Hauptebene (x, y) seitliche Abmessungen zwischen 10 Mikrometern und einigen Millimetern und eine Tiefe entlang einer zur Hauptebene (x, y) senkrechten Achse (z) zwischen einigen Mikrometern und 100 Mikrometern, vorteilhafterweise zwischen 5 und 10 Mikrometern, aufweist.

9. Verfahren zur Herstellung eines thermooptischen Bauteils (100) nach einem der vorstehenden Ansprüche, wobei das thermooptische Bauteil (100) einen Schalter, einen Phasenschieber, einen Modulator, einen Lasersender, einen Verstärker, einen Richtungskoppler, ein Filter und/oder einen Multiplexer bildet.

## Claims

1. A method for manufacturing a thermo-optic component (100), comprising the following steps of:
a) providing a SOI substrate (10) comprising:
- a surface layer (4) made of monocrystalline silicon, extending according to a main plane (x,y) and disposed on a dielectric layer (3), which is itself disposed on a support (1) made of silicon, and
- at least one buried cavity (2), arranged in the support (1) and opening under the dielectric layer (3), and then,
b) forming an optical waveguide (50) extending in the main plane (x,y) and comprising a core (52, 52') formed in the surface layer (4) and surrounded by an optical confinement layer (53) including the dielectric layer (3), and then,
c) producing at least one heating element (60) on the optical waveguide (50), said heating element (60) being positioned, in the main plane (x,y), vertically in line with a portion (52') of the optical waveguide (50), or on either side of said portion (52'), the heating element (60) and the portion (52') of the optical waveguide being vertically in line with the at least one buried cavity (2).

2. The method for manufacturing a thermo-optic component (100) according to the preceding claim, wherein in step b), an opening is formed through the optical waveguide (50) to put the at least one cavity (2) under an external pressure.

3. The method for manufacturing a thermo-optic component (100) according to the preceding claim, wherein said opening is plugged so as to hermetically seal the at least one cavity (2).

4. The method for manufacturing a thermo-optic component (100) according to claim 1, wherein the at least one cavity (2) remains hermetically sealed throughout steps a), b) and c).

5. The method for manufacturing a thermo-optic component (100) according to one of the preceding claims, wherein the dielectric layer (3) is made of silicon oxide and has a thickness between 100nm and 3 microns.

6. The method for manufacturing a thermo-optic component (100) according to one of the preceding claims, wherein the surface layer (4) has a thickness between 100nm and 500nm.

7. The method for manufacturing a thermo-optic component (100) according to one of the preceding claims, wherein the optical confinement layer (53) comprises an additional dielectric layer (3') having a thickness between 0.5 and 1.5 micron.

8. The method for manufacturing a thermo-optic component (100) according to one of the preceding claims, wherein the at least one cavity (2) has lateral dimensions, in the main plane (x,y), between 10 microns and a few millimetres, and a depth, according to an axis (z) normal to the main plane (x,y), between a few microns and 100 microns, advantageously between 5 and 10 microns.

9. The method for manufacturing a thermo-optic component (100) according to one of the preceding claims, wherein said thermo-optic component (100) forms a switch, a phase shifter, a modulator, a laser emitter, an amplifier, a directional coupler, a filter and/or a multiplexer.
